# EUROPEAN PATENT APPLICATION

(11) **EP 2 571 071 A2**
(43) Date of publication of application: **20.03.2013**
(21) Application number: 11183073.3
(22) Date of filing: 28.09.2011
(51) Int. Cl.: H01L 41/09, H01L 27/20

(54) **Transducer and transducer module**

(30) Priority: 19.09.2011 TW 100133579
(71) Applicant: Chief Land Electronic Co. Ltd., Wugu Dist., New Taipei City 248 (TW)
(72) Inventor: Ching, Chia-Nan, 32097 Zhongli City, Taoyuan County (TW); Chuang, Tsi-Yu, 52142 Beidou Township, Changhua County (TW)
(74) Representative: Karakatsanis, Georgios

(57) **Abstract**

Transducers and transducer modules having the transducers are disclosed. An embodiment discloses a transducer (10) that comprises a conductive layer (30E) having a U-shaped slit (100) toward its swing end (A). The slit is configured to enhance a haptic feedback or an acoustic propagation, or adjust a resonant mode.

## Description

### BACKGROUND OF THE INVENTION

### 1. FIELD OF THE INVENTION

The present invention relates to transducers and transducer modules having the transducers.

### 2. DESCRIPTION OF RELATED ART

A transducer is a device that converts one type of energy to another. A motor and an electric generator are common electromechanical transducers. The motor converts electric energy to mechanical energy via electromagnetic induction. The electric generator, on the contrary, converts mechanical energy to electric energy.

Moreover, the transducer may be implemented by smart materials. When a stimuli, such as stress, temperature, electricity, magnetic field, pH, humidity, and so on, is provided to a smart material, one or more properties of the smart material will be changed. The energy conversion can be achieved by employing this feature. Typical smart materials includes piezoelectric material, electro-active polymer (EAP), shape memory alloy (SMA), magnetostrictive material, electrostrictive material, and so on.

Transducers made of smart materials may be applied in various products, such as positioning components, sensors, inkjet printers, and so on. Taking piezoelectric materials as example, the converse piezoelectric effect of which is typically utilized to design a transducer. When an electric field is exerted on a piezoelectric material, it will expand or shrink in a direction rectangular/parallel to the direction of the electric field. One can utilize this feature to design a transducer for converting the electric energy to mechanical energy, and vice versa.

For more output force or response, the smart materials may be stacked or series arranged. Taking piezoelectric materials as example and considering output force as a performance index, the multimorph actuator is better than the bimorph actuator, which is further better than the unimorph actuator. However, the price and the difficulty of assembling the piezoelectric plates of an actuator are proportional to its stacked number.

Moreover, conventional actuators have limited haptic feedback or acoustic propagation, or their resonant mode cannot be adjusted; therefore, a need has arisen to provide a novel structure for enhancing the haptic feedback or the acoustic propagation, or adjust the resonant mode of the transducers.

### SUMMARY OF THE INVENTION

In view of the foregoing, an object of embodiments of this invention is to provide transducers or transducer modules for improving energy conversing efficiency under a low cost condition.

A first embodiment of this invention provides a transducer comprising a conductive layer, which has a first end used as a fixed end and a second used as a swing end. The conductive layer further comprises a U-shaped slit having an opening toward the swing end.

A second embodiment of this invention provides a transducer comprising a conductive layer, which has a central section used as a fixed end and two ends used as two swing ends. Two U-shaped slit are respectively arranged at two sides of the fixed end, and each slit has an opening toward the swing end arranged at the same side.

A third embodiment of this invention provides a transducer module comprising at least one plate and the transducer of the first or second embodiment. Accordingly, the transducers and transducer modules provided by this invention can enhance a haptic feedback or an acoustic propagation, or adjust a resonant mode.

### BRIEF DESCRIPTION OF THE DRAWINGS

FIG. 1A and FIG. 1B show a transducer according to a first embodiment of this invention, in which FIG. 1A is a top view, and FIG. 1B is a cross-section view.
FIG. 2A and FIG. 2B show a transducer according to a second embodiment of this invention, in which FIG. 1A is a top view, and FIG. 1B is a cross-section view.
FIG. 3 shows a bimorph according to the first embodiment of this invention.
FIG. 4A and FIG. 4B show at least one inertial mass being added to the transducers shown in FIG. 1B and FIG. 3
FIG. 5 shows a bimorph according to the second embodiment of this invention.
FIG. 6A and FIG. 6B show at least one inertial mass being added to the transducers shown in FIG. 2B and FIG. 5.
FIG. 7A and FIG. 7B show several examples classified to the second embodiment of this invention.
FIG. 8A to FIG. 8C show several further examples classified to the second embodiment of this invention.
FIG. 9A to FIG. 9D show transducer modules according to a third embodiment of this invention.
FIG. 10A to FIG. 10D show transducer modules according to a fourth embodiment of this invention.
FIG. 11A to FIG. 11B show transducer modules according to a fifth embodiment of this invention.
FIG. 12A to FIG. 12D show transducer modules according to a sixth embodiment of this invention.

### DETAILED DESCRIPTION OF THE INVENTION

Embodiments of this invention disclose transducers and transducer modules having the transducers. The transducers comprise a conductive layer, one or more smart material layers, and one or more electrode layers. One end of the conductive layer is used as a fixed end, and the other end is used as a swing end. Alternatively, the central section of the conductive layer is used as a fixed end, the two ends as two swing ends. The conductive layer further comprises at least a slit having an opening toward the swing end. The smart material layers are disposed on the conductive layer, between the slit and the fixed end, and between the slit and the swing end. The electrode layers are formed on the smart material layers respectively.

In this specification, "central section" refers to a central location and/or its neighboring locations of an object. In addition, the smart material layers may include, but are not limited to, piezoelectric material (e.g., lead zirconate titanate, PZT), electroactive polymer (EAP), shape memory alloy (SMA), magnetostrictive material, pH-sensitive polymers, temperature -responsive polymers, and the like or combinations of the foregoing smart materials.

Furthermore, the transducers, the smart material layers, and the slits may have a regular or irregular profile, such as rectangular shape, round shape, polygon, or combinations thereof. Preferably, the transducers have a rectangular shape, and the slits have a U-shaped profile.

For illustrative purpose, transducers of the following embodiments convert electric energy to mechanical energy, but it should not be limited.

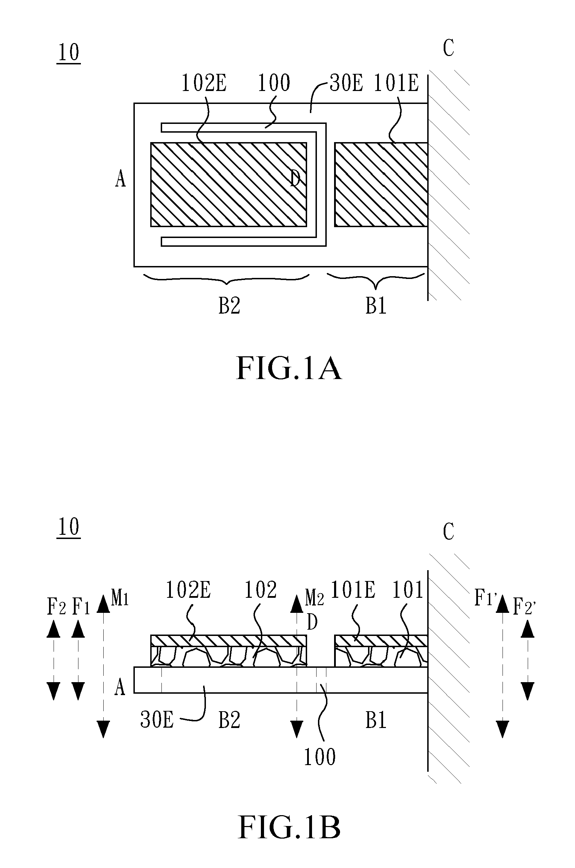

FIG. 1A and FIG. 1B show a transducer 10 according to a first embodiment of this invention, in which FIG. 1A is a top view, and FIG. 1B is a side cross-section view. The transducer 10 of this embodiment primarily includes a conductive layer 30E having two ends, end A and end B, in which end C is used as a fixed end, and end A is used as a swing end. The conductive layer 30E further comprises a U-shaped slit 100 having an opening toward the swing end A. In addition, a first smart material layer 101 is arranged on the conductive layer 30E and between the U-shaped slit 100 and the fixed end C. A second smart material layer 102 is arranged on the conductive layer 30E and between the U-shaped slit 100 and the swing end A. A first electrode layer 101 E is arranged on the first smart material layer 101. A second electrode layer 102E is arranged on the second smart material layer 102.

When electric field is applied on the conductive layer 30E, the first electrode layer 101E, and the second electrode layer 102E, a first action area B1 is formed to allow the first smart material layer 101 for movement, a second action area B2 is formed to allow the second smart material layer 102 for movement, and the swing end A and a free end D are formed within the second action area B2 due to the U-shaped slit 100.

When driving signals are supplied to the first electrode layer 101E and the conductive layer 30E, the first smart material layer 101 will vibrate within the first action area B1, and the vibration is extended from the fixed end C to the swing end A, causing a upward and downward swing movement M1 at the swing end A. The swing movement M1 generates a reciprocating inertial force F1 at the swing end A. The reciprocating inertial force F1 causes the fixed end C generating a reciprocating inertial force F1'. Because the structure layers of the transducer 10, including the conductive layer 30E, the first smart material layer 101, the second smart material layer 102, the first electrode layer 101E, and the second electrode layer 102E, are flexible, some of the inertial force will be converted into bending moment of the transducer 10, and thus F1' is a bit less than and approximate to F1.

In the meantime, when driving signals are supplied to the second electrode layer 102E and the conductive layer 30E, the second smart material layer 102 will vibrate within the second action area B2. By using the swing end A as a pivot, an upward and downward swing movement M2 occurs at the free end D. The swing movement M2 generates a reciprocating inertial force F2 at the swing end A. The reciprocating inertial force F2 causes the fixed end C generating a reciprocating inertial force F2'. Because the structure layers of the transducer 10, including the conductive layer 30E, the first smart material layer 101, the second smart material layer 102, the first electrode layer 101E, and the second electrode layer 102E, are flexible, some of the inertial force will be converted into bending moment of the transducer 10, and thus F2' is a bit less than and approximate to F2.

Accordingly, the total output force at the fixed end C of the transducer 10 is F1'+F2'. In practice, different driving signals may be respectively provided to the first smart material layer 101 and the second smart material layer 102, so as to generate various inertial forces or acoustic propagations, or adjust the resonant mode of the transducer 10.

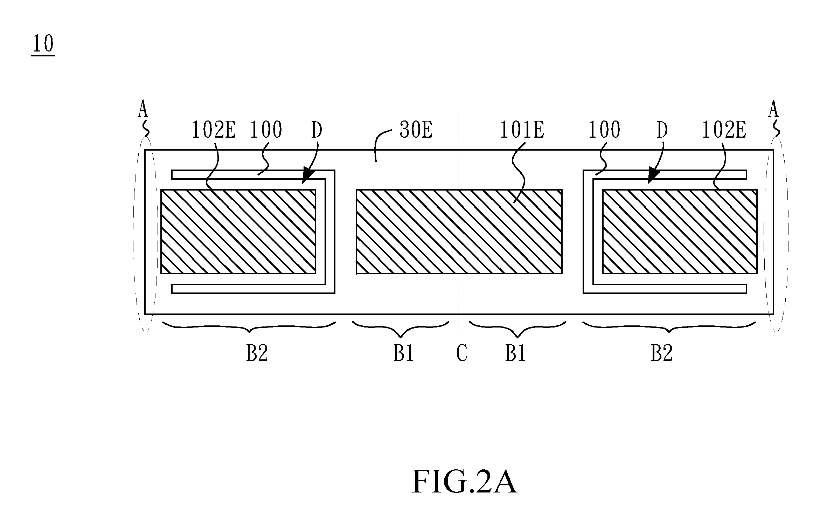

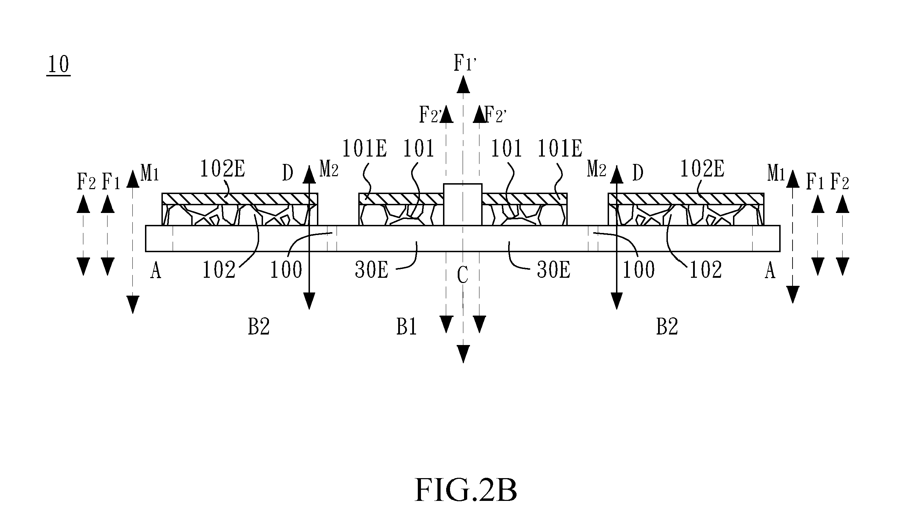

FIG. 2A and FIG. 2B show a transducer 10 according to a second embodiment of this invention, in which FIG. 2A is a top view, and FIG. 2B is a side cross-section view. The transducer 10 of this embodiment primarily includes a conductive layer 30E having two ends used as two swing ends A and a central section used as a fixed end C. The conductive layer 30E further comprises two U-shaped slits 100, and each slit has an opening toward the swing end A arranged at the same side. In addition, a first smart material layer 101 is arranged on the conductive layer 30E and between the two U-shaped slits 100. Two second smart material layers 102 are arranged on the conductive layer 30E and between the U-shaped slit 100 and the swing end A respectively. A first electrode layer 101E is arranged on the first smart material layer 101. Two second electrode layers 102E are respectively arranged on the two second smart material layers 102.

When electric field is applied on the conductive layer 30E, the first electrode layer 101E, and the second electrode layer 102E, a first action area B1 is formed to allow the first smart material layer 101 for movement, a second action area B2 is formed to allow the second smart material layer 102 for movement, and the swing end A and a free end D are formed within the second action area B2 due to the U-shaped slit 100.

When driving signals are supplied to the first electrode layer 101E and the conductive layer 30E, the first smart material layer 101 will vibrate within the first action area B1, and the vibration is extended from the fixed end C to the two swing ends A, causing two upward and downward swing movements M1 at the two swing end A respectively. The swing movement M1 generates a reciprocating inertial force F1 at the swing end A. The reciprocating inertial force F1 causes the fixed end C generating a reciprocating inertial force F1'. Because the structure layers of the transducer 10, including the conductive layer 30E, the first smart material layer 101, the second smart material layer 102, the first electrode layer 101E, and the second electrode layer 102E, are flexible, some of the inertial force will be converted into bending moment of the transducer 10, and thus F1' is a bit less than and approximate to F1.

In the meantime, when driving signals are supplied to the second electrode layer 102E and the conductive layer 30E, the second smart material layer 102 will vibrate within the second action area B2. By using the swing end A as a pivot, an upward and downward swing movement M2 occurs at the free end D. The swing movement M2 generates a reciprocating inertial force F2 at the swing end A. The reciprocating inertial force F2 causes the fixed end C generating a reciprocating inertial force F2'. Because the structure layers of the transducer 10, including the conductive layer 30E, the first smart material layer 101, the second smart material layer 102, the first electrode layer 101E, and the second electrode layer 102E, are flexible, some of the inertial force will be converted into bending moment of the transducer 10, and thus F2' is a bit less than and approximate to F2.

Accordingly, the total output force at the fixed end C of the transducer 10 is F1'+F2'. In practice, different driving signals may be provided to the first smart material layer 101 and the second smart material layer 102 respectively, so as to generate various inertial forces or acoustic propagations, or adjust the resonant mode of the transducer 10.

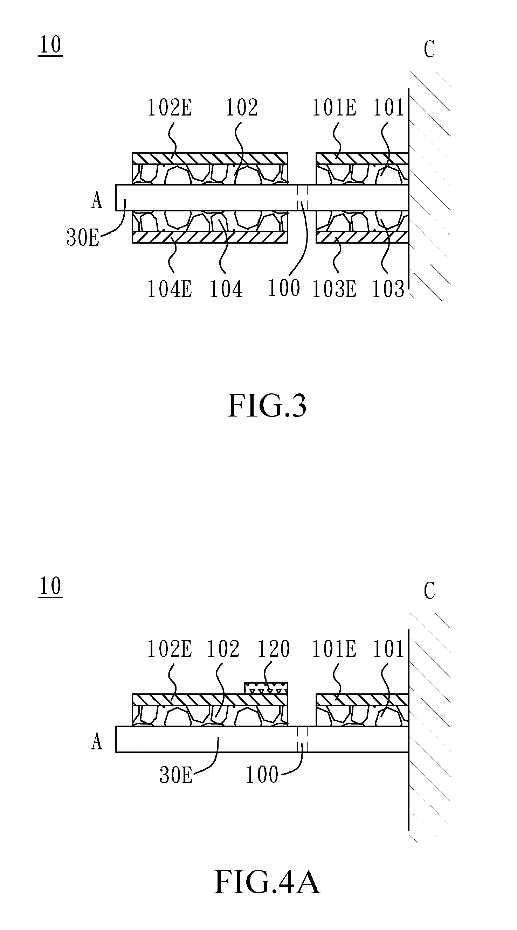

In practice, the transducer 10 of the first embodiment may include two or more smart material layers. FIG. 3 shows a cross-section of a transducer 10 having two smart material layers. In addition to the structure of FIG. 1B, the transducer 10 further comprises: a third smart material layer 103 arranged below the conductive layer 30E and corresponding to the first smart material layer 101; a third electrode layer 103E arranged below the third smart material layer 103; a fourth smart material layer 104 arranged below the conductive layer 30E and corresponding to the second smart material layer 102; and a fourth electrode layer 104E arranged below the fourth smart material layer 104. Similarly, employing this manner can form a transducer having multiple smart material layers.

Moreover, to further increase the inertial force, enhance the swing amplitude, or adjust the resonant mode, at least one inertial mass may be disposed at a suitable position of the transducer 10.

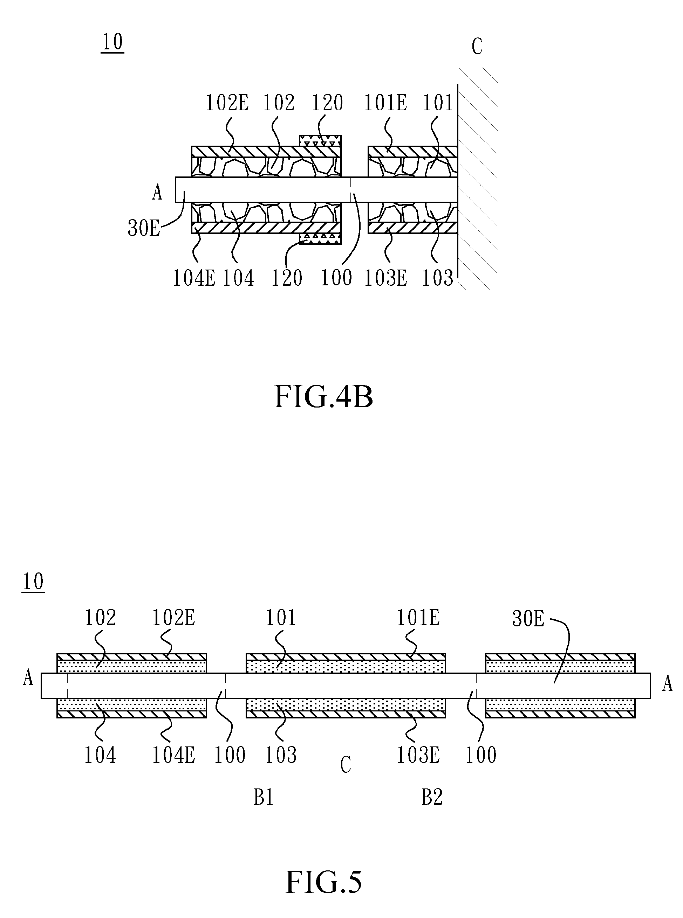

FIG. 4A and FIG. 4B respectively illustrate that at least one inertial mass 120 is fixed at suitable position of the second electrode layer 102E and the fourth electrode layer 104E.

Taking the transducers of FIG. 1B and FIG.3 as two examples, in FIG. 4A there is at least one inertial mass 120 placed upon a suitable position of the second electrode layer 102E. Besides inertial mass on second electrode layer 102E, another inertial mass 120 also can be put on the fourth electrode layer 104E, as shown in FIG. 4B, to further enhance the inertial force acting on the fixed end C.

The inertial mass 120 may be made of various materials and shapes, such as high-density material, e.g., metal, or material with high Young's modulus, e.g., zirconium oxide. Notice that the number and position of the inertial mass 120 are not limited.

The inertial mass 120 increases the total mass and alters the resonant frequency of the transducer 10. In detail, the inertial mass 120 increases the mass loading of the second smart material layer 102 and the fourth smart material layer 104. Therefore, when driving signals drive the second smart material layer 102 and the fourth smart material layer 104, a reciprocating swing movement is formed at the free end D by using the swing end as a pivot. Because the inertial mass 120 will increase the loading of the free end D, and the reciprocating swing movement is maintained, the increased inertial mass 120 will increase the inertial force at the swing end A. The increased inertial force at the swing end A will increase the inertial force of the fixed end C. By doing so, the inertial mass 120 increases the inertial force of the fixed end C.

In practice, the transducer 10 of the second embodiment may include two or more smart material layers. FIG. 5 shows a cross-section of a transducer 10 having two smart material layers. In addition to the structure of FIG. 2B, the transducer 10 further comprises: a third smart material layer 103 arranged below the conductive layer 30E and corresponding to the first smart material layer 101; a third electrode layer 103E arranged below the third smart material layer 103; two fourth smart material layers 104 arranged below the conductive layer 30E and corresponding to the two second smart material layers 102 respectively; and two fourth electrode layer 104E arranged below the two fourth smart material layers 104 respectively. Similarly, employing this manner can form a transducer having multiple smart material layers.

Moreover, to further increase the inertial force, enhance the swing amplitude, or adjust the resonant mode, at least one inertial mass may be disposed at a suitable position of the transducer 10.

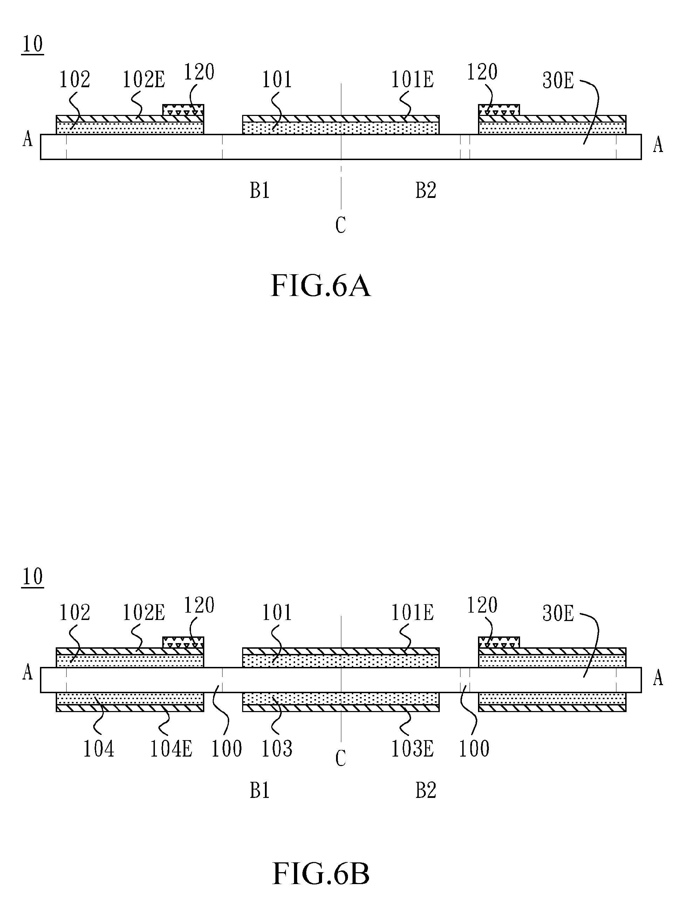

Taking the transducers of FIG. 2B and FIG.5 as two examples, FIG. 6A and FIG. 6B respectively illustrate at least one inertial mass 120 is fixed at suitable position of the second electrode layer 102E and the fourth electrode layer 104E.

The inertial mass 120 may be made of various materials and shapes, such as high-density material, e.g., metal, or material with high Young's modulus, e.g., zirconium oxide. Notice that the number and position of the inertial mass are not limited.

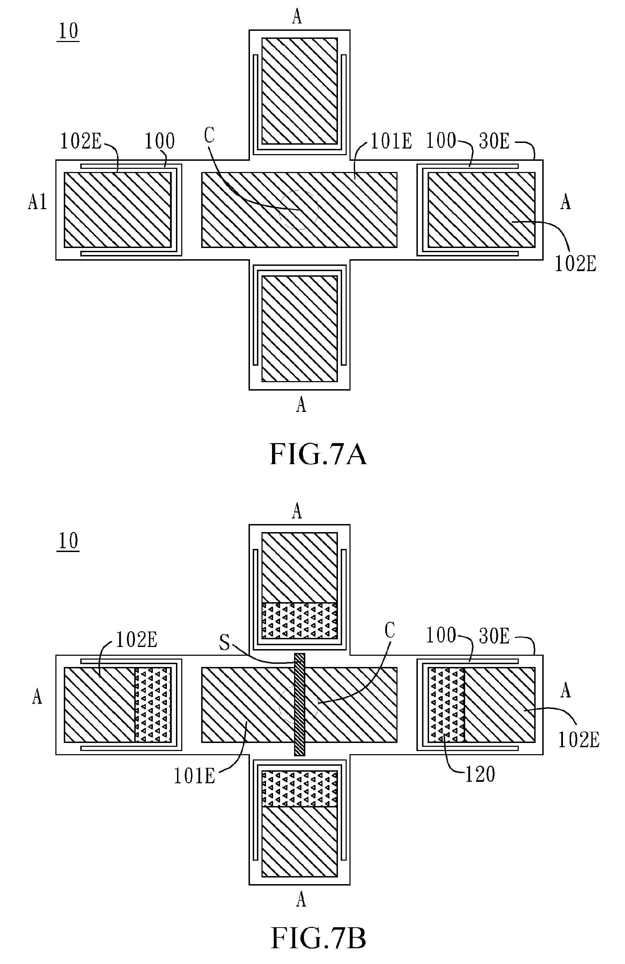

FIG. 7A and FIG. 7B show a top view of a transducer 10 classified to, i.e., the modification of, the second embodiment of this invention. For illustrative purpose, the transducer 10 may be, but is not limited to, a unimorph actuator, a bimorph actuator, or a multimorph actuator. In addition, symbol S denotes a fixed area or a support member in practice. In this embodiment, the transducer 10 has a cross shape, and its conductive layer 30E has a central section as the fixed end C, four ends as the swing ends A, and four U-shaped slits 100 with an opening toward the four swing ends A respectively. In addition, if the transducer 10 is a unimorph actuator, a first electrode layer 101E and a first smart material layer 101 below the first electrode layer 101 are disposed on the conductive layer 30E and between the four U-shaped slits 100, and a second electrode layer 102E and a second smart material layer 102 below the second electrode layer 102E are arranged on the conductive layer 30E and between each U-shaped slit 100 and swing end A. Moreover, referring to FIG. 7B, the transducer 10 may comprise at least one inertial mass 120, and the number and position of the inertial mass 120 are not limited.

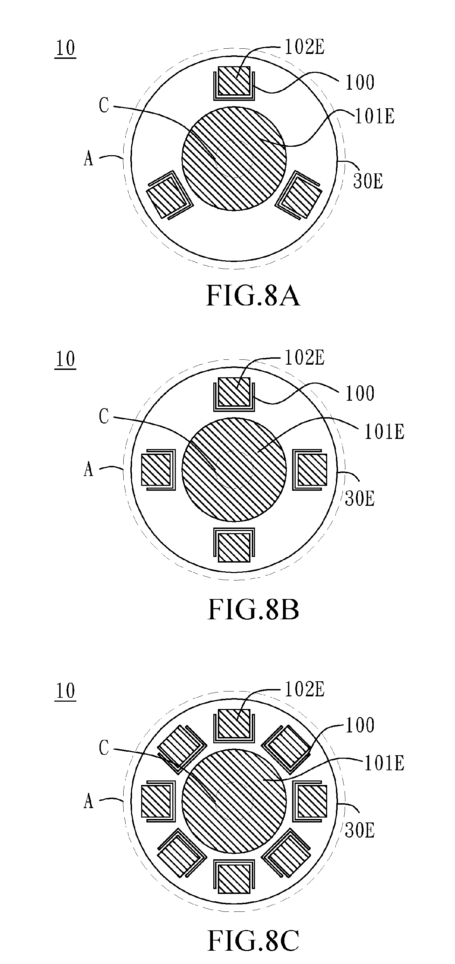

FIG. 8A to FIG. 8C are top views showing several transducer classified to, i.e., the modification of, the second embodiment of this invention. For illustrative purpose, the transducer 10 may be, but is not limited to, a unimorph actuator, a bimorph actuator, or a multimorph actuator. In addition, symbol S denotes a fixed area or a support member in practice. In this embodiment, the transducer 10 has a round shape, and its conductive layer 30E has a central section as the fixed end C, a continuous edge as the swing end A, and several U-shaped slits 100 with an opening toward the swing end A. In addition, if the transducer is a unimorph actuator, a first electrode layer 101 E and a first smart material layer 101 below the first electrode layer 101E are disposed on the conductive layer 30E and between the U-shaped slits 100 and the fixed end C, and a second electrode layer 102E and a second smart material layer 102 below the second electrode layer 102E are disposed on the conductive layer 30E and between each U-shaped slit 100 and swing end A. Moreover, the transducer 10 may comprise at least one inertial mass (not shown), and the number and position of the inertial mass are not limited.

The transducers of the above-mentioned embodiments may be applied to a transducer module, thereby increasing the energy conversion efficiency.

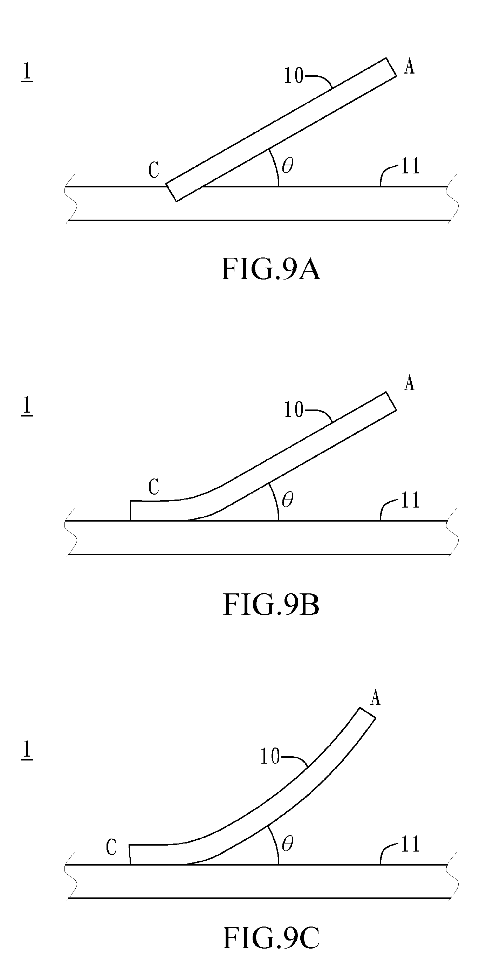

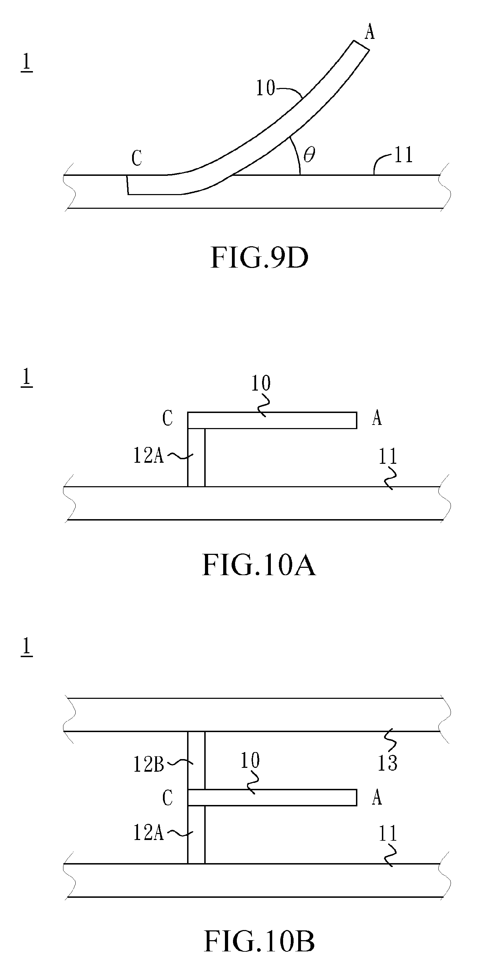

FIG. 9A to FIG. 9D show transducer modules according to the third embodiment of this invention. In this embodiment, the transducer module 1 primarily includes a transducer 10 and a first plate 11. The transducer 10 may be various transducers classified to the first embodiment of this invention, such as transducers shown in FIG.1A, FIG.1B, FIG. 3, FIG.4A, and FIG. 4B. The transducer 10 employs the fixed end C to fix the first plate 11, and an angle θ may be present between the transducer 10 and the first plate 11. In this specification, the verb "fix" may include, but is not limited to, "sticking," "embedding," "resisting," "locking," "screwing," "soldering," or other methods known in the art. In practice, as shown in FIG. 9A and FIG. 9B, the transducer 10 may be flat; alternatively, as shown in FIG. 9C and FIG. 9D, the transducer 10 may be curved. In this embodiment, the transducer 10 comprises at least one slit 100 (as shown in the foregoing embodiments as in FIG. 1A) having an opening toward the swing end A. The first plate 11 may be, but is not limited to, a screen, a touch panel, a frame, a substrate, or a housing. In this embodiment, when electric field is applied on the transducer 10, as the fixed end C is fixed, the swing end A will swing and thus cause the fixed end C generating inertial force, resulting in that the first plate 11 vibrates and thus push the air to generate the acoustic wave or haptic feedback.

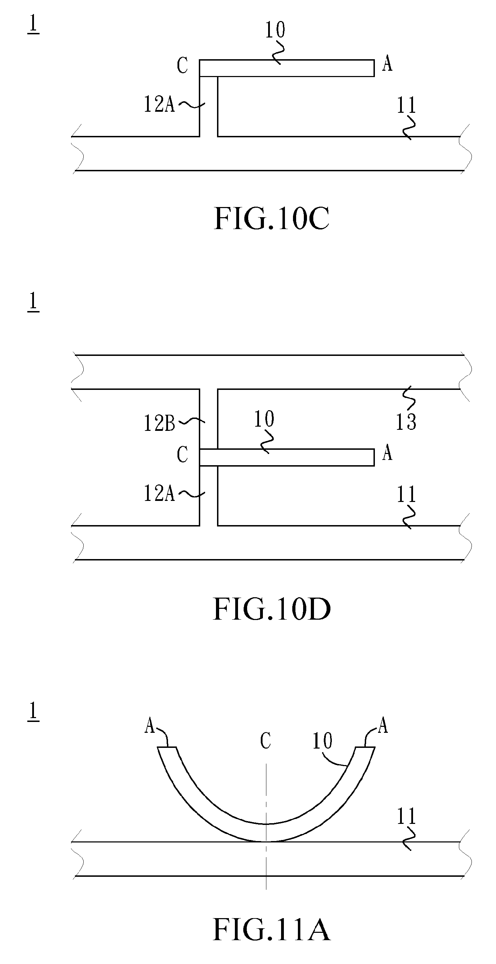

FIG. 10A to FIG. 10D show transducer modules according to the fourth embodiment of this invention. This embodiment may be considered as a modification of the first embodiment, and two embodiments are different in that in this embodiment, a support member 12A is employed to fix the central section of the transducer 10 and a first plate 11, or support members 12A/B are employed to fix the central section of the transducer 10, the first plate 11, and a second plate 13 respectively. The first end of the support member 12A fixes the first plate 11, and the second end of the support member 12A fixes the fixed end C. The first end of the support member 12B fixes the fixed end C, and the second end of the support member 12B fixes the second plate 13. In this embodiment, the support member 12A/B may be made of any material, such as metals or polymers. The support member 12A/B may be hollow or solid, may have a tube, cylindrical, or other shapes, and the quantity may be one or greater than one. In one modified embodiment, at least one of the support member 12A/B is a damper, which may be an elastic member such as a spring or an elastic rubber. In another embodiment, at least one of the support member 12A/B is a smart material. In addition, as shown in FIG. 10A and FIG. 10B, the first plate 11, the support member 12A, the second plate 13, and the support member 12B may be separately formed. As shown in FIG. 10C and FIG. 10D, the first plate 11 and the support member 12A, and the second plate 13 and the support member 12B, may be integrally formed respectively.

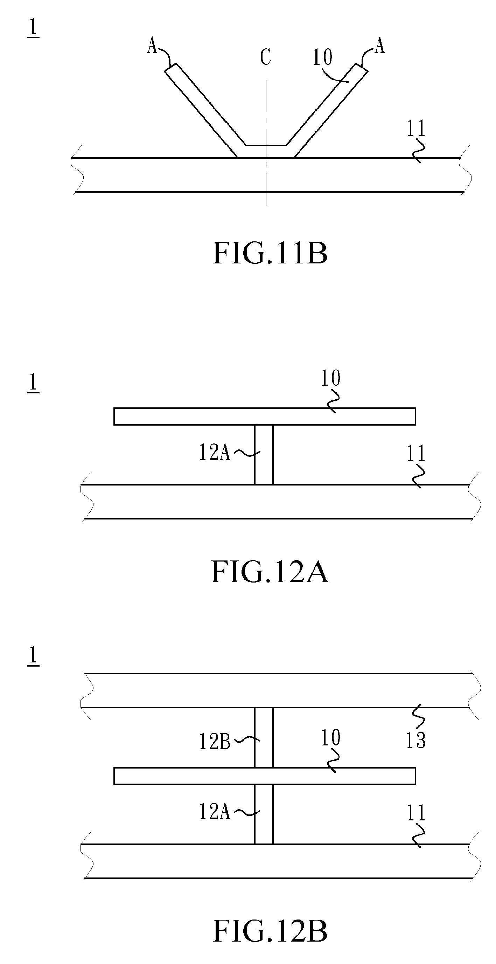

FIG. 11A and FIG. 11B show transducer modules according to the fifth embodiment of this invention. In this embodiment, the transducer module 1 primarily includes a transducer 10 and a first plate 11. The transducer 10 may be various transducers classified to the second embodiment of this invention, such as transducers shown in FIG.2A, FIG.2B, FIG. 5, FIG.6A, FIG. 6B, and FIG. 8A to FIG. 8C. The central section of the transducer 10 is used as the fixed end C to fix the first plate 11. In practice, as shown in FIG. 11A, the transducer 10 may be curved; alternatively, as shown in FIG. 11B, the transducer 10 may be flat and bent. In this embodiment, the transducer 10 comprises at least two slits 100 (as shown in the foregoing embodiments as in FIG. 2A) having an opening toward the swing end A arranged at the same side. The first plate 11 may be, but is not limited to, a screen, a touch panel, a frame, a substrate, or a housing. In this embodiment, when electric field is applied on the transducer 10, as the fixed end C is fastened, the swing end A will swing and thus cause the fixed end C generating inertial force, resulting in that the first plate 11 vibrates and thus pushes the air to generate the acoustic wave or haptic feedback.

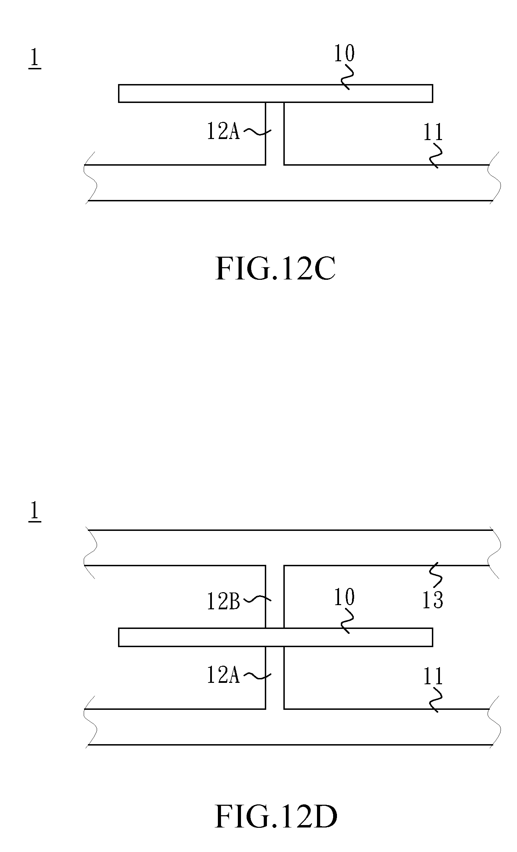

FIG. 12A to FIG. 12D show transducer modules according to the sixth embodiment of this invention. This embodiment may be considered as a modification of the fifth embodiment, and two embodiments are different in that in this embodiment, a support member 12A is employed to fix the central section of the transducer 10 and a first plate 11, or support members 12A/B are employed to fix the central section of the transducer 10, the first plate 11, and a second plate 13 respectively. The first end of the support member 12A fixes the first plate 11, and the second end of the support end 12A fixes the central section of the transducer 10. The first end of the support member 12B fixes the central section of the transducer 10, and the second end of the support member 12B fixes the second plate 13. In this embodiment, the support members 12A/B may be made of any material, such as metals or polymers. The support members 12A/B may be hollow or solid, may have a tube, cylindrical, or other shapes, and the quantity may be one or greater than one. In one modified embodiment, at least one of the support member 12A/B comprises a damper, which may be an elastic member such as a spring or an elastic rubber. In another embodiment, at least one of the support member 12A/B comprises a smart material. In addition, as shown in FIG. 12A and FIG. 12B, the first plate 11, the support member 12A, the second plate 13, and the support member 12B, may be separately formed. As shown in FIG. 12C and FIG. 12D, the first plate 11 and the support member 12A, and the second plate 13 and the support member 12B, may be integrally formed respectively.

Accordingly, the embodiments of this invention provide transducer modules featuring in transducers with slits and inertial masses, thereby enhancing haptic feedback or acoustic propagation, or adjust resonant mode.

Although specific embodiments have been illustrated and described, it will be appreciated by those skilled in the art that various modifications may be made without departing from the scope of the present invention, which is intended to be limited solely by the appended claims.

## Claims

1. A transducer, comprising:
a conductive layer, comprising a first end used as a fixed end, a second end used as a swing end, and a slit having an opening toward the swing end.

2. The transducer of claim 1, further comprising:
a first smart material layer, arranged on the conductive layer and between the fixed end and the slit;
a second smart material layer, arranged on the conductive layer located between the swing end and the slit;
a first electrode layer, arranged on the first smart material layer; and
a second electrode layer, arranged on the second smart material layer.

3. The transducer of Claim 2, wherein a first action area is formed at the area that the first smart material layer is located, and a second action area is formed at the area that the second smart material layer is located.

4. The transducer of Claim 2, wherein the first smart material layer and the second smart material are made of a piezoelectric material or an electro-active polymer.

5. The transducer of Claim 2, further comprising:
a third smart material layer arranged below the conductive layer and corresponding to the first smart material layer;
a third electrode layer arranged below the third smart material layer;
a fourth smart material layer arranged below the conductive layer and corresponding to the second smart material layer; and
a fourth electrode layer arranged below the fourth smart material layer.

6. A transducer, comprising:
a conductive layer, comprising a central section used as a fixed end, two ends used as two swing ends, and two slits, wherein each slit has an opening toward the swing end arranged at the same side.

7. The transducer of claim 6, further comprising:
a first smart material layer, arranged on the conductive layer and between the fixed end and the two slits;
two second smart material layers, arranged on the conductive layer located between the swing end and the slit at the same side respectively;
a first electrode layer, arranged on the first smart material layer; and
two second electrode layers, arranged on the two second smart material layers respectively.

8. The transducer of Claim 7, wherein a first action area is formed at the area that the first smart material layer is located, and a second action area is formed at the area that the second smart material layer is located.

9. The transducer of Claim 7, wherein the first smart material layer and the second smart material layer are made of a piezoelectric material or an electro-active polymer.

10. The transducer of Claim 7, further comprising:
a third smart material layer arranged below the conductive layer and corresponding to the first smart material layer;
a third electrode layer arranged below the third smart material layer;
two fourth smart material layers arranged below the conductive layer and corresponding to the two second smart material layers respectively; and
two fourth electrode layers arranged below the two fourth smart material layers respectively.

11. A transducer module, comprising:
a first plate; and
a transducer, comprising a conductive layer, the conductive layer comprising a first end used as a fixed end and a second end used as a swing end, or, the conductive layer comprising a central section used as a fixed end and two ends used as two swing ends;
wherein the conductive layer further comprises at least one slit having an opening toward the swing end.

12. The transducer module of claim 11, further comprising:
a first smart material layer, arranged on the conductive layer and between the fixed end and the slit;
at least a second smart material layer, arranged on the conductive layer and between the swing end and the slit;
a first electrode layer, arranged on the first smart material layer; and
at least a second electrode layers, arranged on the second smart material layer.

13. The transducer module of Claim 12, wherein the first smart material layer and the second smart material are made of a piezoelectric material or an electro-active polymer.

14. The transducer module of Claim 12, further comprising:
a third smart material layer arranged below the conductive layer and corresponding to the first smart material layer;
a third electrode layer arranged below the third smart material layer;
at least a fourth smart material layer arranged below the conductive layer and corresponding to the second smart material layer; and
at least a fourth electrode layer arranged below the fourth smart material layer.

15. The transducer module of Claim 11, wherein the first plate comprises a screen, a touch panel, a frame, a substrate, or a housing.

16. The transducer module of Claim 15, wherein a first support member is employed to fix the transducer and the first plate.

17. The transducer module of Claim 16, wherein a second support member is employed to fix the transducer and a second plate, and the second plate comprises the screen, the touch panel, the frame, the substrate, or the housing.

18. The transducer module of Claim 17, wherein at least one of the first support member and the second support member comprises a smart material or a damper.
